# EUROPEAN PATENT APPLICATION

(11) **EP 2 808 914 A1**
(43) Date of publication of application: **03.12.2014**
(21) Application number: 14170657.2
(22) Date of filing: 30.05.2014
(51) Int. Cl.: H01L 51/50

(54) **Organic electroluminescence display device**

(30) Priority: 31.05.2013 JP 2013116308
(71) Applicant: Japan Display Inc., Tokyo 105-0003 (JP)
(72) Inventor: Toyoda, Hironori, Tokyo 105-0003 (JP); Ito, Masato, Tokyo 105-0003 (JP); Sato, Toshihiro, Tokyo 105-0003 (JP)
(74) Representative: Beetz & Partner

(57) **Abstract**

An organic electroluminescence display device includes a first light-emitting unit (44) and a second light-emitting unit (56) that are stacked between a cathode (36) and an anode (30). The first light-emitting unit (44) includes a first electron injection layer (54) and a first light-emitting layer (50) that are stacked. The first electron injection layer (54) is arranged closer to the cathode side than the first light-emitting layer (50) is. The second light-emitting unit (56) includes a second electron injection layer (68) and a second light-emitting layer (64) that are stacked. The second electron injection layer (68) is arranged closer to the cathode side than the second light-emitting layer (64) is. Each of the first electron injection layer (54) and the second electron injection layer (68) includes a compound containing lithium. The number of particles of lithium is from 0.1 mmol/cm³ to 0.86 mmol/cm³.

## Description

### BACKGROUND OF THE INVENTION

### 1. Field of the Invention

The present invention relates to an organic electroluminescence display device.

### 2. Description of the Related Art

In organic electroluminescence display devices, an organic electroluminescence display device that realizes color display using a white light source and color filters has been known. For example, light-emitting layers that emit lights of different colors are stacked to mix the colors of the lights, so that white light is produced.

Moreover, it has been known that lithium is contained in an electron injection layer for efficiently injecting electrons into a light-emitting layer. Such a technique is disclosed in, for example, JP 2008-028371 A and JP 2008-141174 A.

According to JP 2008-028371 A, the film thicknesses of electron injection layers are different according to colors. The density of a metal in the electron injection layer is increased as the film thickness of the electron injection layer decreases, so that light extraction efficiency can be improved.

According to JP 2008-141174 A, the thickness of an electron injection layer containing an alkali metal is optimized for respective colors so as to intensify lights emitted from light-emitting layers, so that luminous efficiency can be improved.

Moreover, JP 2008-028371 A and JP 2008-141174 A each disclose an organic EL display device in which light-emitting layers that emit lights of different colors are formed respectively in different regions in a plane.

The evaluation of optical characteristics of a so-called tandem element, which includes a light-emitting unit that includes a light-emitting layer of blue light and a light-emitting unit in which a light-emitting layer of red light and a light-emitting layer of green light are stacked, revealed that current efficiency and a drive voltage greatly changed depending on the density of lithium contained in the electron injection layer. The evaluation also revealed that the tendencies of dependence on the lithium density were different between the light-emitting units.

When the lithium density is adjusted for the respective electron injection layers of the light-emitting units, an apparatus for that purpose is separately needed, resulting in an increase in introduction and management costs. Therefore, it is desired to optimize the characteristics of the tandem element while considering the lithium density dependence of the respective light-emitting units.

JP 2008-028371 A discloses the configuration in which the film thicknesses of the electron injection layers of the organic light-emitting elements of respective colors are different and the density of a metal or a metal compound in the electron injection layer is increased as the film thickness of the electron injection layer decreases. JP 2008-141174 A discloses that the thickness of the electron injection layer is adjusted for respective emission colors so as to intensify lights emitted through light-emitting layers by a plurality of organic light-emitting elements of different emission colors. However, neither of the documents discloses a tandem element that produces white light by mixing lights of different colors.

### SUMMARY OF THE INVENTION

It is an object of the invention to improve emission brightness with reduced power consumption at the same power.
(1) An organic electroluminescence display device according to an aspect of the invention includes: a cathode; an anode; and a first light-emitting unit and a second light-emitting unit that are stacked between the cathode and the anode, wherein the first light-emitting unit includes a first electron injection layer and a first light-emitting layer that are stacked, the second light-emitting unit includes a second electron injection layer and a second light-emitting layer that are stacked, each of the first electron injection layer and the second electron injection layer includes a compound containing lithium, and the number of particles of the lithium is from 0.1 mmol/cm³ to 0.86 mmol/cm³. The inventor of the invention carried out experiments on the number of particles of lithium of the first electron injection layer and the second electron injection layer for improving emission brightness with reduced power consumption at the same power. As a result, the inventor has found numerical values with which a difference in the number of particles of lithium between the first electron injection layer and the second electron injection layer is confined within a predetermined range and the power consumption is reduced.
(2) In the organic electroluminescence display device according to (1), a difference in the number of particles of the lithium between the first electron injection layer and the second electron injection layer may be 0.3 mmol/cm³ or less.
(3) In the organic electroluminescence display device according to (1) or (2), the first light-emitting layer may include a red light-emitting layer that emits red light and a green light-emitting layer that emits green light, the red light-emitting layer and the green light-emitting layer being stacked, the second light-emitting layer may include a blue light-emitting layer that emits blue light, and the number of particles of the lithium may be set to from 0.63 mmol/cm³ to 0.86 mmol/cm³.
(4) In the organic electroluminescence display device according to (1) or (2), the first light-emitting layer may include a blue light-emitting layer that emits blue light, the second light-emitting layer may include an yellow light-emitting layer that emits yellow light, and the number of particles of the lithium may be set to from 0.1 mmol/cm³ to 0.8 mmol/cm³.
(5) In the organic electroluminescence display device according to any one of (1) to (4), each of the first electron injection layer and the second electron injection layer may include a compound of tris(8-hydroxyquinolinato)aluminum and the lithium.

### BRIEF DESCRIPTION OF THE DRAWINGS

Fig. 1 is a cross-sectional view of an organic electroluminescence display device according to an embodiment of the invention.
Fig. 2 is a diagram showing details of an organic electroluminescence layer shown in Fig. 1.
Fig. 3A is a graph showing changes in drive voltage when changing the lithium density of a first electron injection layer in a first light-emitting unit; and Fig. 3B is a graph showing changes in luminous efficiency when changing the lithium density of the first electron injection layer in the first light-emitting unit.
Fig. 4A is a graph showing changes in drive voltage when changing the lithium density of a second electron injection layer in a second light-emitting unit; and Fig. 4B is a graph showing changes in luminous efficiency when changing the lithium density of the second electron injection layer in the second light-emitting unit.
Fig. 5A is a graph showing changes in drive voltage when changing the lithium densities of the first electron injection layer and the second electron injection layer in the same manner; and Fig. 5B is a graph showing changes in luminous efficiency when changing the lithium densities of the first electron injection layer and the second electron injection layer in the same manner.
Fig. 6 is a graph showing the lithium density dependence of power consumption calculated from the experiment results.
Fig. 7A is a graph showing changes in drive voltage when changing the lithium density of the first electron injection layer in the first light-emitting unit; and Fig. 7B is a graph showing changes in luminous efficiency when changing the lithium density of the first electron injection layer in the first light-emitting unit.
Fig. 8A is a graph showing changes in drive voltage when changing the lithium density of the second electron injection layer in the second light-emitting unit; and Fig. 8B is a graph showing changes in luminous efficiency when changing the lithium density of the second electron injection layer in the second light-emitting unit.
Fig. 9A is a graph showing changes in drive voltage when changing the lithium density of an electron injection layer; and Fig. 9B is a graph showing changes in luminous efficiency when changing the lithium density of the electron injection layer.
Fig. 10 is a graph showing the Li density dependence of power consumption calculated based on the results in Figs. 9A and 9B.

### DETAILED DESCRIPTION OF THE INVENTION

Hereinafter, an embodiment of the invention will be described with reference to the drawings.

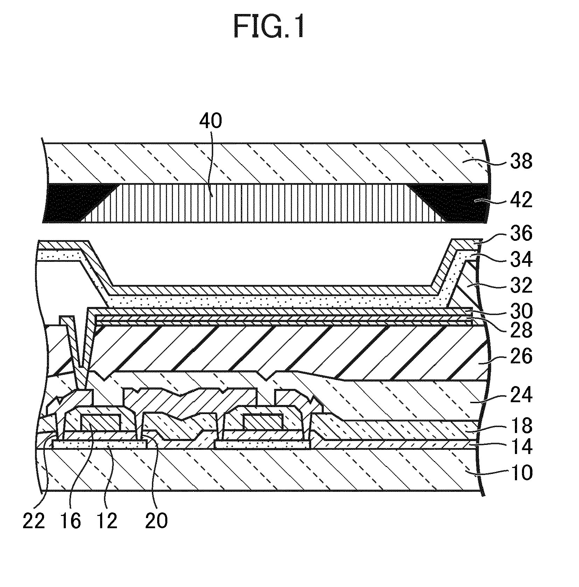

Fig. 1 is a cross-sectional view of an organic electroluminescence display device according to the embodiment of the invention. The organic electroluminescence display device includes a light-transmissive first substrate 10 made of glass or the like. A semiconductor layer 12 is formed on the first substrate 10. A gate insulating film 14 is formed to cover the semiconductor layer 12. A gate electrode 16 is formed on the gate insulating film 14. An inter-layer insulating film 18 is formed to cover the gate electrode 16. A source electrode 20 and a drain electrode 22 are provided to penetrate through the inter-layer insulating film 18 so as to reach the semiconductor layer 12. The semiconductor layer 12, the source electrode 20, the drain electrode 22, and the gate electrode 16 are components of a thin film transistor.

A passivation film 24 is formed on the inter-layer insulating film 18 so as to cover the source electrode 20 and the drain electrode 22. An insulating layer 26 is provided on the passivation film 24. A light reflective layer 28 for reflecting light is formed on the insulating layer 26.

An anode 30 (for example, a pixel electrode) is provided on the light reflective layer 28. The anode 30 penetrates through the insulating layer 26 and is electrically connected to one of the source electrode 20 and the drain electrode 22. The insulating layer 26 is located below a plurality of the anodes 30. A plurality of thin film transistors are located below the insulating layer 26.

A bank 32 made of an insulator such as a resin is provided so as to surround at least a portion of the anode 30. An organic electroluminescence layer 34 is formed on the anode 30 surrounded by the bank 32. A portion of the organic electroluminescence layer 34 is located also on the bank 32.

A light-transmissive cathode 36 (for example, a common electrode) is formed above the anode 30 so as to reach above the bank 32. The cathode 36 is formed so as to entirely cover all of the anodes 30. The organic electroluminescence layer 34 is arranged between the anode 30 and the cathode 36. By applying a voltage to the anode 30 and the cathode 36, holes and electrons are injected respectively from the anode and the cathode into the organic electroluminescence layer 34. The injected holes and electrons are combined in the organic electroluminescence layer 34 to emit light.

The organic electroluminescence display device includes a light-transmissive second substrate 38 made of glass or the like. The second substrate 38 is arranged so as to face the first substrate 10 with a gap therebetween. A color filter layer 40 is provided on a surface of the second substrate 38 on the first substrate 10 side. The color filter layer 40 overlaps the organic electroluminescence layer 34. A space is formed between the organic electroluminescence layer 34 and the color filter layer 40. That is, hollow sealing is applied. As a modified example, the space may be filled with a resin. A black matrix layer 42 is formed on the surface of the second substrate 38 on the first substrate 10 side.

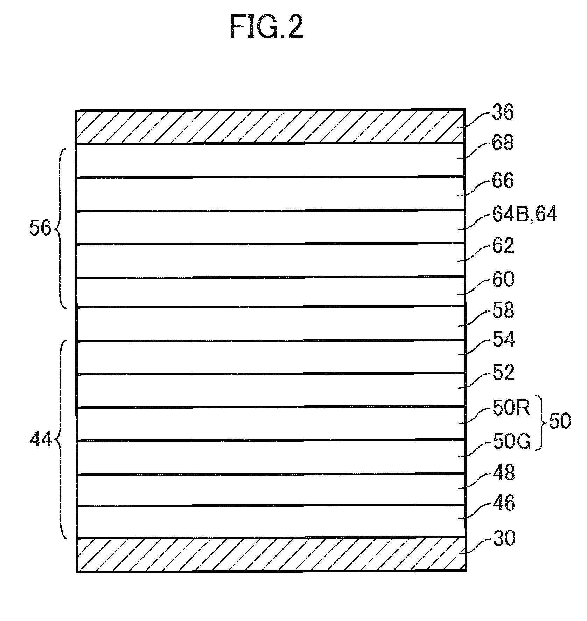

Fig. 2 is a diagram showing details of the organic electroluminescence layer 34 shown in Fig. 1. The organic electroluminescence layer 34 includes a first light-emitting unit 44 that is stacked between the cathode 36 and the anode 30. The first light-emitting unit 44 includes a first hole injection layer 46 and a first hole transport layer 48 that are stacked. The first light-emitting unit 44 includes a first light-emitting layer 50. The first light-emitting layer 50 includes a red light-emitting layer 50R that emits red light and a green light-emitting layer 50G that emits green light. The red light-emitting layer 50R and the green light-emitting layer 50G are stacked. The first light-emitting unit 44 includes a first electron transport layer 52 on the cathode 36 side of the first light-emitting layer 50. The first light-emitting unit 44 includes a first electron injection layer 54 on the cathode 36 side of the first electron transport layer 52. The first electron injection layer 54 includes a compound of tris(8-hydroxyquinolinato)aluminum and lithium. The first electron injection layer 54 is stacked above the first light-emitting layer 50. The first electron injection layer 54 is arranged closer to the cathode 36 than the first light-emitting layer 50 is.

The organic electroluminescence layer 34 includes a second light-emitting unit 56 that is stacked between the cathode 36 and the anode 30. A separation layer 58 is present between the first light-emitting unit 44 and the second light-emitting unit 56. The second light-emitting unit 56 includes a second hole injection layer 60 and a second hole transport layer 62 that are stacked. The second light-emitting unit 56 includes a second light-emitting layer 64. The second light-emitting layer 64 includes a blue light-emitting layer 64B that emits blue light. The second light-emitting unit 56 includes a second electron transport layer 66 on the cathode 36 side of the second light-emitting layer 64. The second light-emitting unit 56 includes a second electron injection layer 68 on the cathode 36 side of the second electron transport layer 66. The second electron injection layer 68 includes a compound of tris(8-hydroxyquinolinato)aluminum and lithium. The second electron injection layer 68 is stacked above the second light-emitting layer 64. The second electron injection layer 68 is arranged closer to the cathode 36 than the second light-emitting layer 64 is.

The first electron injection layer 54 and the second electron injection layer 68 are doped with lithium for promoting injection of electrons from the cathode 36. Characteristics of the first electron injection layer 54 and the second electron injection layer 68 vary depending on the number of particles (molar concentration) of lithium contained in a unit volume. If the molar concentration is too low, the effect is not produced; and conversely, if the molar concentration is too high, the injection of electrons is conceivably prevented. That is, there is an optimum range of the molar concentration. The optimum range of molar concentration is different between the first light-emitting unit 44 and the second light-emitting unit 56, and therefore, it is normally desirable to separately adjust the molar concentration for the first electron injection layer 54 and the second electron injection layer 68. However, different apparatuses are prepared or a readjustment of an apparatus is needed for that purpose, resulting in an increase in cost. Hence, it is desirable to set the molar concentrations of the first electron injection layer 54 and the second electron injection layer 68 to be the same in design.

In the embodiment, the number of particles of lithium is from 0.1 mmol/cm³ to 0.8 mmol/cm³ in each of the first electron injection layer 54 and the second electron injection layer 68. Moreover, a difference in the number of particles of lithium between the first electron injection layer 54 and the second electron injection layer 68 is 0.3 mmol/cm³ or less.

According to the embodiment, since the difference in the number of particles of lithium between the first electron injection layer 54 and the second electron injection layer 68 is 0.3 mmol/cm³ or less, the first electron injection layer 54 and the second electron injection layer 68 can be formed using the same apparatus without making a readjustment.

Moreover, by setting the number of particles of lithium to from 0.1 mmol/cm³ to 0.8 mmol/cm³, the emission brightness can be improved with reduced power consumption at the same power. This was found through experiments by the inventor of the invention. The experiments will be described below.

### [Example 1]

For an experiment, the first light-emitting unit 44 and the second light-emitting unit 56 shown in Fig. 2 were separately produced, and elements in each of which the first light-emitting unit 44 or the second light-emitting unit 56 was interposed between an anode and a cathode were separately prepared. The first light-emitting unit 44 and the second light-emitting unit 56 include the first electron injection layer 54 and the second electron injection layer 68, respectively, each of which contains lithium. Then, the tendency of changes in characteristics when changing the lithium density contained in each of the first electron injection layer 54 and the second electron injection layer 68 was investigated.

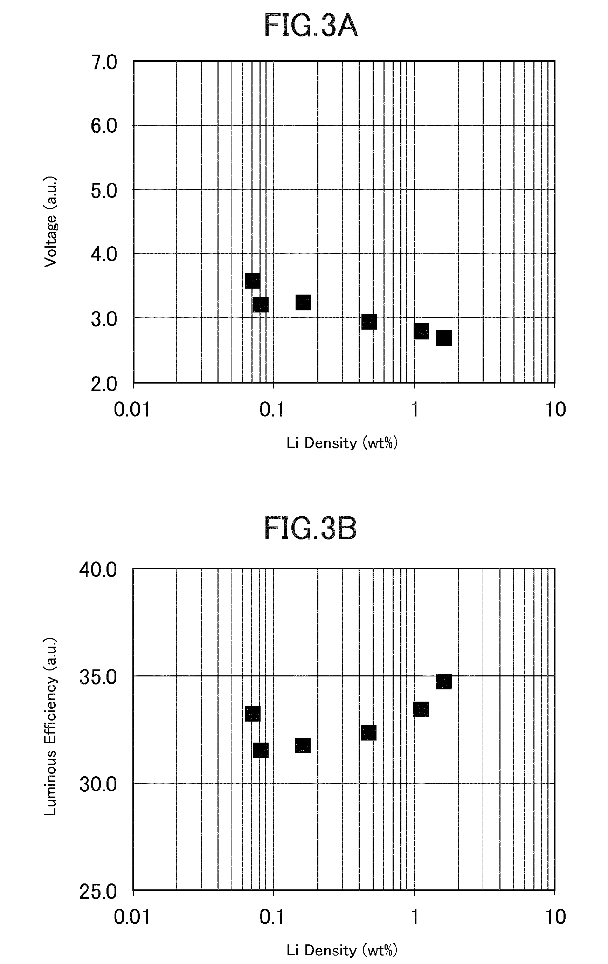

Fig. 3A is a graph showing changes in drive voltage when changing the lithium density of the first electron injection layer 54 in the element of the first light-emitting unit 44 alone. Fig. 3B is a graph showing changes in luminous efficiency when changing the lithium density of the first electron injection layer 54 in the element of the first light-emitting unit 44 alone. In the first light-emitting unit 44, it has been observed that as the lithium density of the first electron injection layer 54 increases, the drive voltage tends to decrease and the luminous efficiency tends to increase.

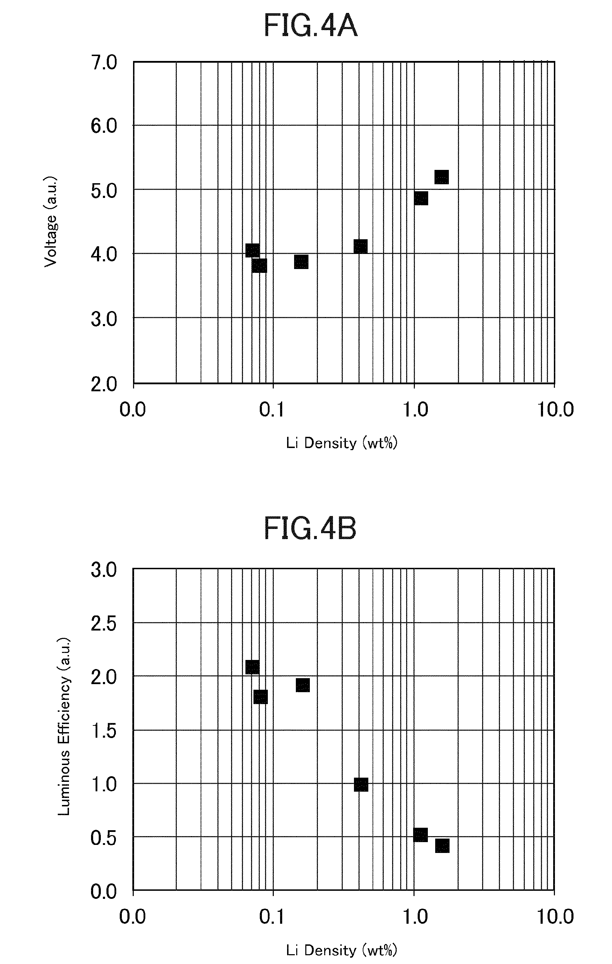

Fig. 4A is a graph showing changes in drive voltage when changing the lithium density of the second electron injection layer 68 in the element of the second light-emitting unit 56 alone. Fig. 4B is a graph showing changes in luminous efficiency when changing the lithium density of the second electron injection layer 68 in the element of the second light-emitting unit 56 alone. In the second light-emitting unit 56, it has been observed that as the lithium density of the second electron injection layer 68 increases, the drive voltage tends to increase and the luminous efficiency tends to decrease, which is opposite to the first light-emitting unit 44. As described above, the first electron injection layer 54 and the second electron injection layer 68 have different lithium dependence. Therefore, it was predicted that there would be settings of lithium density to make the characteristics locally favorable when the first and second electron injection layers are stacked. The density of lithium can be easily investigated by, for example, inductively coupled plasma emission spectroscopy, inductively coupled plasma mass spectrometry, atomic absorption spectrometry, secondary ion mass spectrometry, or the like.

Next, an element including the organic electroluminescence layer 34 shown in Fig. 2 was prepared. The organic electroluminescence layer 34 has a structure in which the first light-emitting unit 44 and the second light-emitting unit 56 are stacked. The tendency of changes in characteristics when changing the lithium densities contained in the first electron injection layer 54 and the second electron injection layer 68 in the same manner in the first light-emitting unit 44 and the second light-emitting unit 56 was investigated. The first electron injection layer 54 and the second electron injection layer 68 are deposited using the same apparatus under the same condition. It is considered that a difference in lithium density between the first electron injection layer 54 and the second electron injection layer 68 is within a range of error associated with the apparatus (0.21 wt% or less).

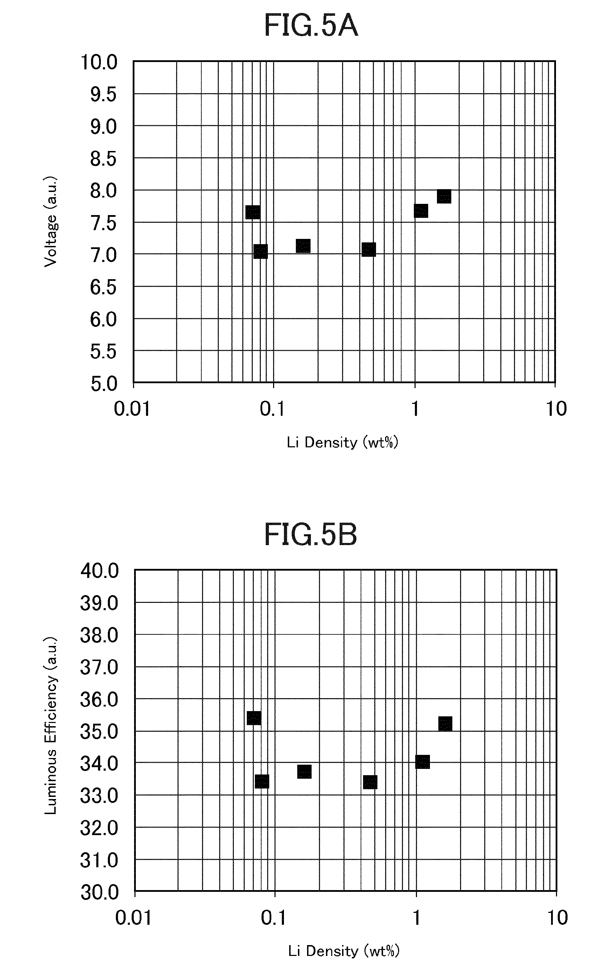

Fig. 5A is a graph showing changes in drive voltage when changing the lithium densities of the first electron injection layer 54 and the second electron injection layer 68 in the same manner. Fig. 5B is a graph showing changes in luminous efficiency when changing the lithium densities of the first electron injection layer 54 and the second electron injection layer 68 in the same manner. As a result of verification, the voltage was minimized when the lithium density was around 0.07 wt% and around 0.56 wt%. It has been found that the luminous efficiency has substantially the same value when the lithium density is from 0.07 to 0.56 wt% while the luminous efficiency is improved when the lithium density is lower or higher than the range.

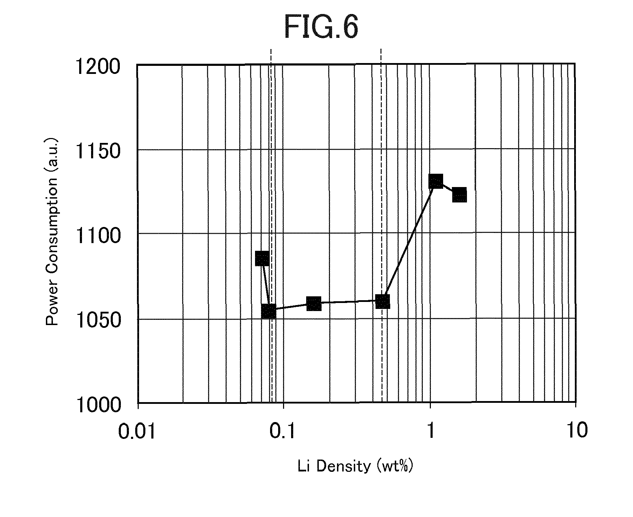

Fig. 6 is a graph showing the lithium density dependence of power consumption calculated from the result of the experiment. The power consumption is substantially flat when the lithium density is within the range of from 0.07 to 0.56 wt%. Moreover, it has been found that the power consumption was rapidly increased when the Li density was lower than 0.07 wt% or greater than 0.56 wt%. As a result of this, it has been found that for reducing the power consumption, the lithium density may be set within the range of from 0.07 to 0.56 wt%.

When the molecular weight of lithium is 7 g/mol and the density of a material (organic material) constituting the first electron injection layer 54 and the second electron injection layer 68 before being doped with lithium is 1 g/cm³, the relational expression of 1 wt% = 1.43 mmol/cm³ is established between weight percent concentration and molar concentration. When this expression is used, the lithium density is from 0.07 to 0.56 wt% = 0.1 to 0.8 mmol/cm³, and the range of error associated with the apparatus is 0.21 wt% = 0.3 mmol/cm³.

From the fact described above, it has been found that by setting the number of particles of lithium to from 0.1 mmol/cm³ to 0.8 mmol/cm³ and setting a difference in the number of particles of lithium between the first electron injection layer 54 and the second electron injection layer 68 to 0.3 mmol/cm³ or less, the power consumption is minimized.

### [Example 2]

In Example 1, a red-and-green light-emitting unit was formed as the first light-emitting unit 44, and a blue light-emitting unit was formed as the second light-emitting unit 56. In Example 2, on the other hand, a blue light-emitting unit was formed as the first light-emitting unit 44, and an yellow light-emitting unit was formed as the second light-emitting unit 56, in Fig. 2.

The first light-emitting layer 50 is a blue light-emitting layer, the second light-emitting layer 64 is an yellow light-emitting layer, and white light is obtained from blue light and yellow light.

When a plurality of emission colors are stacked in a thickness direction as in this Example, the viewing angle dependence of light emission is small at a position close to the reflective layer 28 while the viewing angle dependence increases with increased distance from the reflective layer 28. Therefore, it is desirable that a color whose color change due to viewing angle is desired to be reduced is arranged in the first light-emitting unit.

Similarly to Example 1, the first light-emitting unit 44 and the second light-emitting unit 56 were separately produced, and elements in each of which the first light-emitting unit 44 or the second light-emitting unit 56 was interposed between an anode and a cathode were separately prepared. The first light-emitting unit 44 and the second light-emitting unit 56 include the first electron injection layer 54 and the second electron injection layer 68, respectively, each of which contains lithium.

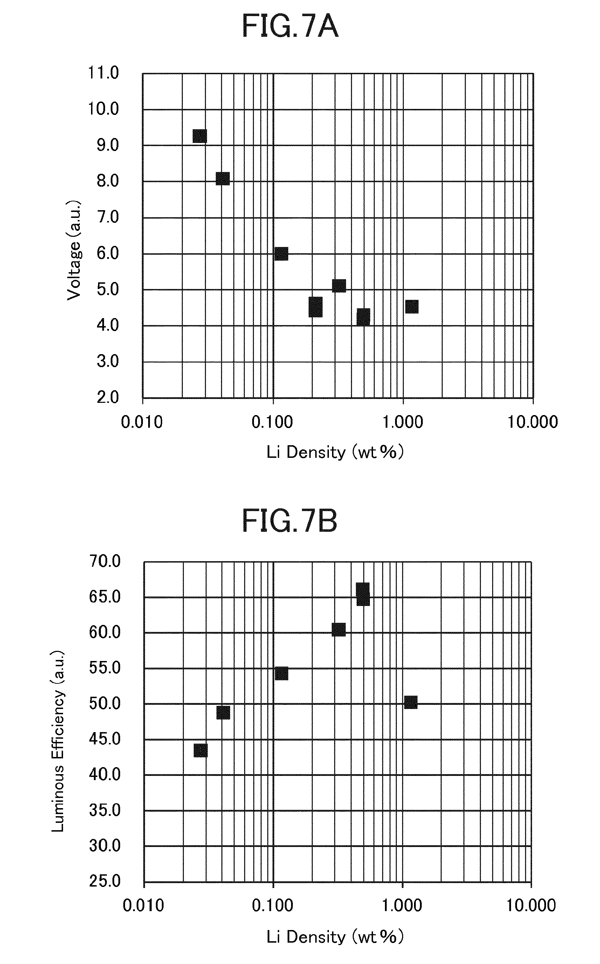

Fig. 7A is a graph showing changes in drive voltage when changing the lithium density of the first electron injection layer 54 in the first light-emitting unit 44. Fig. 7B is a graph showing changes in luminous efficiency when changing the lithium density of the first electron injection layer 54 in the first light-emitting unit 44.

In the first light-emitting unit 44, it has been observed that the drive voltage tends to decrease as the Li density increases. Moreover, it has been observed that the luminous efficiency tends to increase when the Li density is in a range of from 0.007 wt% to 0.497 wt% while the luminous efficiency tends to decrease when the Li density is from 0.497 to 1.16 wt%.

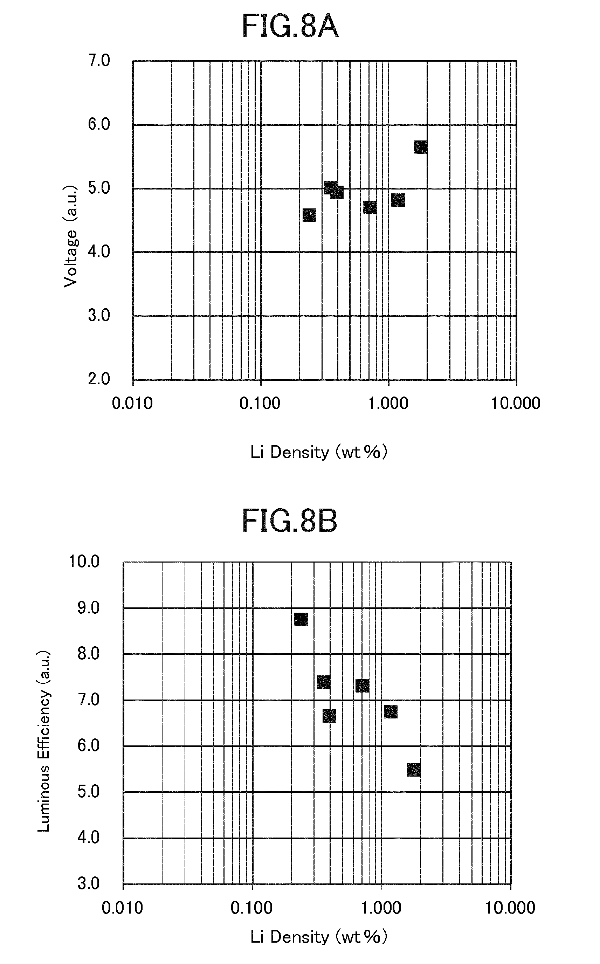

Fig. 8A is a graph showing changes in drive voltage when changing the lithium density of the second electron injection layer 68 in the second light-emitting unit 56. Fig. 8B is a graph showing changes in luminous efficiency when changing the lithium density of the second electron injection layer 68 in the second light-emitting unit 56.

In the second light-emitting unit 56, it has been observed that the drive voltage tends to increase as the Li density increases. Moreover, it has been observed that the luminous efficiency tends to decrease as the Li density increases.

The first light-emitting unit 44 and the second light-emitting unit 56 in Example 2 show opposite characteristic tendencies in both the drive voltage and the luminous efficiency as the Li density increases.

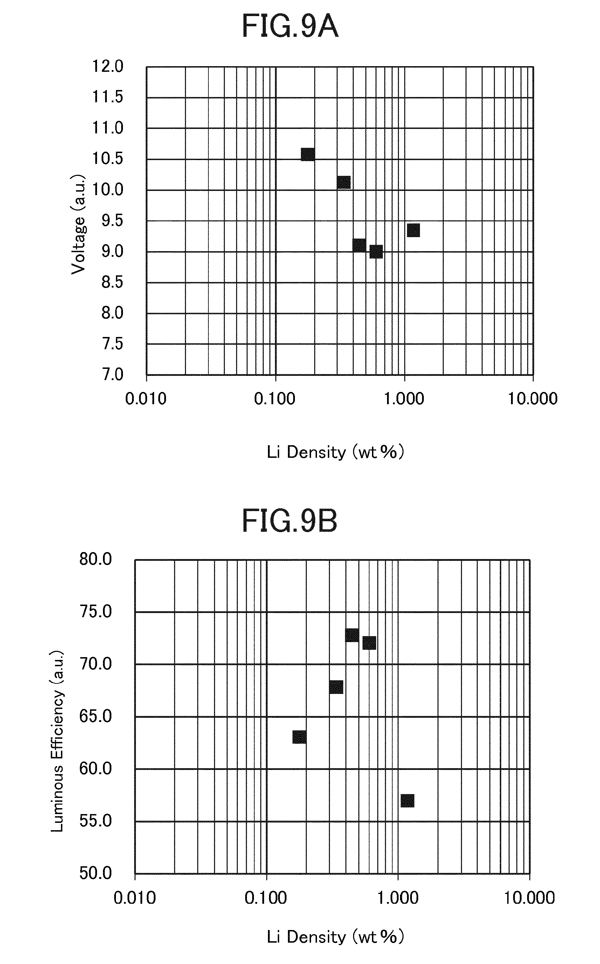

Figs. 9A and 9B are graphs showing changes in lithium density and drive voltage or luminous efficiency as a white light-emitting element. Fig. 9A is a graph showing changes in drive voltage when changing the lithium density of an electron injection layer. Fig. 9B is a graph showing changes in luminous efficiency when changing the lithium density of the electron injection layer. The element measured at this time has a structure in which the second light-emitting unit 56 is stacked on the first light-emitting unit 44 as shown in Fig. 2. Moreover, the layer configuration of Fig. 2 was applied to the element configuration of Fig. 1. A first electron injection layer and a second electron injection layer were formed using the same apparatus. Therefore, variation in Li density between the first electron injection layer and the second electron injection layer is within a range of variation associated with the manufacturing apparatus (0.21 wt% or less).

As a result of verification, the voltage was minimum when the Li density was from 0.44 to 0.60 wt%, while the luminous efficiency was maximum when the Li density was from 0.44 to 0.60 wt%.

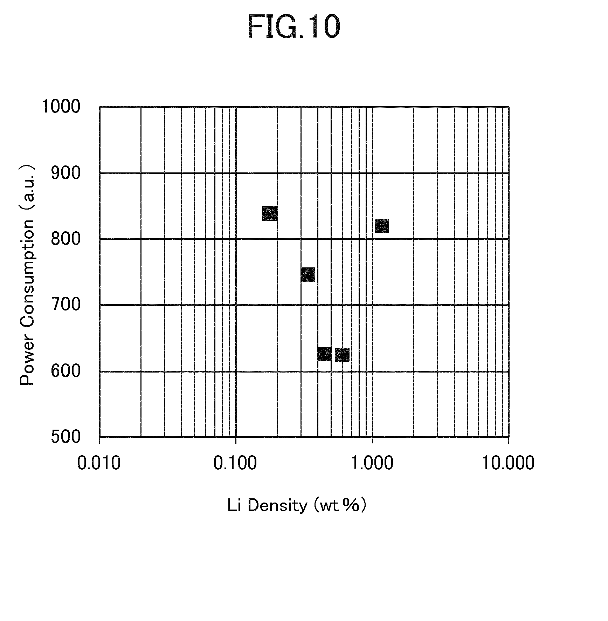

Fig. 10 is a graph showing the Li density dependence of power consumption calculated based on the results in Figs. 9A and 9B. The power consumption is substantially flat when the Li density is within the range of from 0.44 to 0.60 wt%. Moreover, the power consumption is rapidly increased when the Li density is lower than 0.44 wt% or greater than 0.60 wt%.

As a result of this, for reducing the power consumption of a tandem element that emits white light by stacking layers, the Li density may be set within the range of from 0.44 to 0.60 wt%.

The above-described tendencies are expressed characteristically when a plurality of light-emitting units are stacked and the Li densities of both units are set to be the same. By setting a Li density different from that of an element of a single color, the power consumption in a stacked element can be minimized.

Moreover, when the relational expression of 1 wt% = 1.43 mmol/cm³ is used similarly to Example 1, the Li density is from 0.44 to 0.60 wt% = 0.63 to 0.86 mmol/cm³, and the range of variation associated with the apparatus is 0.21 wt% = 0.3 mmol/cm³.

From the above, when the number of particles of Li in a plurality of electron injection layers is in a specific range, for example, in a range of from 0.63 to 0.86 mmol/cm³ and a difference in the number of particles of Li between the plurality of electron injection layers is adjusted to be 0.3 mmol/cm³ or less, the power consumption in a stacked element can be minimized.

As can be seen from Example 1 and Example 2 described above, in an organic EL light-emitting element in which light-emitting units are stacked, the number of particles of lithium may be at least within a range of from 0.1 mmol/cm³ to 0.86 mmol/cm³.

While there have been described what are at present considered to be certain embodiments of the invention, it will be understood that various modifications may be made thereto, and it is intended that the appended claims cover all such modifications as fall within the true spirit and scope of the invention.

## Claims

1. An organic electroluminescence display device comprising:
a cathode (36);
an anode (30); and
a first light-emitting unit (44) and a second light-emitting unit (56) that are stacked between the cathode (36) and the anode (30), wherein
the first light-emitting unit (44) includes a first electron injection layer (54) and a first light-emitting layer (50) that are stacked,
the second light-emitting unit (56) includes a second electron injection layer (68) and a second light-emitting layer (64) that are stacked,
each of the first electron injection layer (54) and the second electron injection layer (68) includes a compound containing lithium, and the number of particles of the lithium is from 0.1 mmol/cm³ to 0.86 mmol/cm³.

2. The organic electroluminescence display device according to claim 1, wherein
a difference in the number of particles of the lithium between the first electron injection layer (54) and the second electron injection layer (68) is 0.3 mmol/cm³ or less.

3. The organic electroluminescence display device according to claim 1 or 2, wherein
the first light-emitting layer (50) includes a red light-emitting layer (50R) that emits red light and a green light-emitting layer (50G) that emits green light, the red light-emitting layer (50R) and the green light-emitting layer (50G) being stacked,
the second light-emitting layer (64) includes a blue light-emitting layer (64B) that emits blue light, and
the number of particles of the lithium is set to from 0.63 mmol/cm³ to 0.86 mmol/cm³.

4. The organic electroluminescence display device according to claim 1 or 2, wherein
the first light-emitting layer (50) includes a blue light-emitting layer (50B) that emits blue light,
the second light-emitting layer (64) includes a yellow light-emitting layer that emits yellow light, and
the number of particles of the lithium is set to from 0.1 mmol/cm³ to 0.8 mmol/cm³.

5. The organic electroluminescence display device according to any one of claims 1 to 4, wherein
each of the first electron injection layer (54) and the second electron injection layer (68) includes a compound of tris(8-hydroxyquinolinato)aluminum and the lithium.
